# DEMANDE DE BREVET EUROPEEN

(11) **EP 1 378 798 A1**
(43) Date de publication de la demande: **07.01.2004**
(21) Numéro de dépôt: 03291291.7
(22) Date de dépôt: 28.05.2003
(51) Int. Cl.: G03F 7/20, B41C 1/18, G03F 7/16, G03F 7/00

(54) **Procédé de fabrication de ceintures d'impression**

(30) Priorité: 07.06.2002 FR 0207031
(71) Demandeur: Chevrillon-Philippe Industrie, 92100 Boulogne (FR)
(72) Inventeur: De Ponnat, Arnaud, 18200 St-Amand-Montrond (FR); Bernou, Mickael, 79200 Parthenay (FR); Leleu, Damien, 08700 La Grandville (FR); Faye, Renaud, 49250 St-Georges du Bois (FR)
(74) Mandataire: Rémont, Claude

(57) **Abrégé**

Une chaîne de fabrication (8) d'une ceinture d'impression (1) comprenant une bande formant support (2) et une résine (3) photopolymérisée formant des caractères d'impression (76), comporte des moyens d'épandage (21) adaptés à épandre la résine (3) sur la bande (2), des moyens de photopolymérisation (29) adaptés à solidifier la partie de la résine (3) devant correspondre aux caractères d'impression (76), des moyens d'enlèvement (54) adaptés à enlever la résine (3) non photopolymérisée de la bande (2), et des moyens d'entraînement (10,53,72) sont adaptés à entraîner la bande (2) en translation de sorte que chacune de ses sections transversales passe successivement au droit des moyens d'épandage (21), des moyens de photopolymérisation (29) et des moyens d'enlèvement (54).

## Description

La présente invention concerne un procédé de fabrication de ceintures d'impression pouvant être utilisées notamment pour l'impression par typographie ou par flexographie, et une chaîne de fabrication de telles ceintures.

Une ceinture d'impression concernée par la présente invention est du type comprenant une bande formant support (par exemple en polyester) et une résine polymérisée, fixée sur une face de la bande, formant les caractères d'impression.

Une telle ceinture est utilisée dans l'imprimerie par typographie ou flexographie : elle est disposée en boucle fermée autour de deux rouleaux et est entraînée en rotation par ceux-ci. Une bande de papier (ou équivalent) à imprimer est pressée contre les caractères d'impression imprégnés d'encre.

On connaît un procédé de fabrication de telles ceintures du type comportant une étape d'épandage pendant laquelle une résine liquide est épandue sur une surface plane, une étape de photopolymérisation pendant laquelle seule la partie de la résine devant correspondre aux caractères d'impression est soumise à une exposition lumineuse de façon à être solidifiée, et une étape d'enlèvement pendant laquelle la résine non photopolymérisée est enlevée de la surface sur laquelle elle a été épandue.

Selon un tel procédé, la résine liquide est épandue sur une feuille plane, ensuite elle est insolée par une lumière UV, un film formant le négatif de caractères à imprimer étant disposé entre la source lumineuse et la feuille, à proximité immédiate de la résine. Par cette insolation, seule la partie de la résine ne se trouvant pas cachée par le film négatif (la partie devant former les caractères d'impression) est photopolymérisée (et solidifiée). Une fois la photopolymérisation réalisée, la résine liquide non photopolymérisée est enlevée de la feuille, et la feuille est collée sur la bande formant support.

Le problème d'un tel procédé est son temps de mise en oeuvre relativement long.

Une solution précédemment proposée est d'agencer les pages dans le négatif de sorte à pouvoir disposer un maximum de pages dans un film négatif, de manière à diminuer le nombre de feuilles utilisées. En conséquence, une fois la résine non polymérisée enlevée de la feuille, celle-ci doit être découpée de façon à séparer les pages les unes des autres, puis les pages de caractères doivent être collées à la bande formant support selon l'agencement permettant l'impression du livre. Toutefois, un tel procédé présente comme inconvénient principal de nécessiter beaucoup de temps pour la découpe et l'agencement des pages.

Un but de la présente invention est donc de réaliser un procédé de fabrication plus rapide et moins coûteux.

Selon l'invention, lors de l'étape d'épandage du procédé de fabrication du type précité, la résine liquide est épandue directement sur la face supérieure de la bande formant support disposée horizontalement, et la bande formant support est montée mobile longitudinalement en translation de sorte que chaque section transversale de la bande passe successivement d'un moyen permettant la réalisation d'une étape de fabrication à un autre.

L'invention concerne aussi la chaîne de fabrication d'une ceinture de type précité.

Comme indiqué ci-dessus, une chaîne de fabrication classique comporte des moyens d'épandage adaptés à épandre la résine liquide, des moyens de photopolymérisation adaptés à solidifier la partie de la résine devant correspondre aux caractères d'impression, et des moyens d'enlèvement adaptés à enlever la résine non photopolymérisée de la surface sur laquelle elle a été épandue.

Selon l'invention, les moyens d'épandage sont adaptés à épandre la résine directement sur la face supérieure de la bande, les moyens de photopolymérisation sont disposés en aval des moyens d'épandage et comprennent une source lumineuse de photopolymérisation disposée au-dessus de la bande formant support, les moyens d'enlèvement sont disposés en aval des moyens de photopolymérisation, et des moyens d'entraînement sont adaptés à entraîner la bande en translation, selon une direction longitudinale, de sorte que chacune de ses sections transversales passe successivement au droit des moyens d'épandage, des moyens de photopolymérisation et des moyens d'enlèvement.

Un tel procédé et une telle chaîne de fabrication permettent ainsi de réduire de façon importante les coûts de production d'une ceinture d'impression, bien que l'agencement des pages du livre à imprimer lors de l'étape de photopolymérisation doit correspondre à celui de la ceinture d'impression finie.

D'autres avantages et précision apparaîtront dans la description qui va suivre.

Aux dessins annexés, donnés uniquement à titre d'exemple non limitatif :
- la figure 1 est une vue de coupe simplifiée d'une ceinture d'impression utilisée dans une imprimerie industrielle ;
- les figure 2a, 2b et 2c représentent une vue en coupe longitudinale d'une chaîne de fabrication selon l'invention ;
- la figure 3 est une vue en coupe longitudinale d'un moyen d'épandage ;
- la figure 4 est une vue en coupe transversale d'un moyen de photopolymérisation ;
- la figure 5 est une vue en perspective d'un cadre support d'un moyen de photopolymérisation ;
- la figure 6 est une autre vue en perspective du cadre support ;
- la figure 7 est une vue en coupe de l'agencement d'un cadre principal d'un moyen de photopolymérisation avant sa mise en position basse ;
- la figure 8 est une vue similaire à la figure 7, le cadre principal étant en position basse ; et

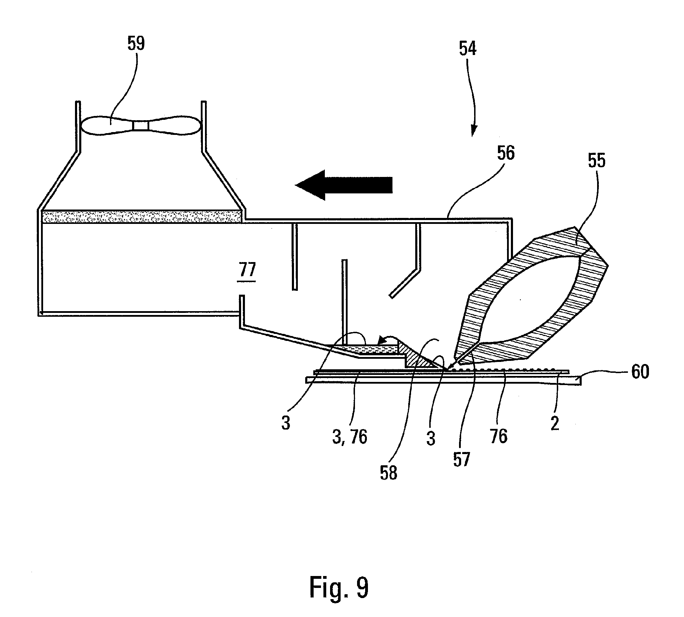

- la figure 9 est une vue en coupe transversale d'un moyen d'enlèvement.

Une ceinture d'impression 1 concernée par la présente invention comprend une bande formant support 2 et une résine 3, polymérisée, fixée sur une face 4 de la bande formant support 2, formant les caractères d'impression 76.

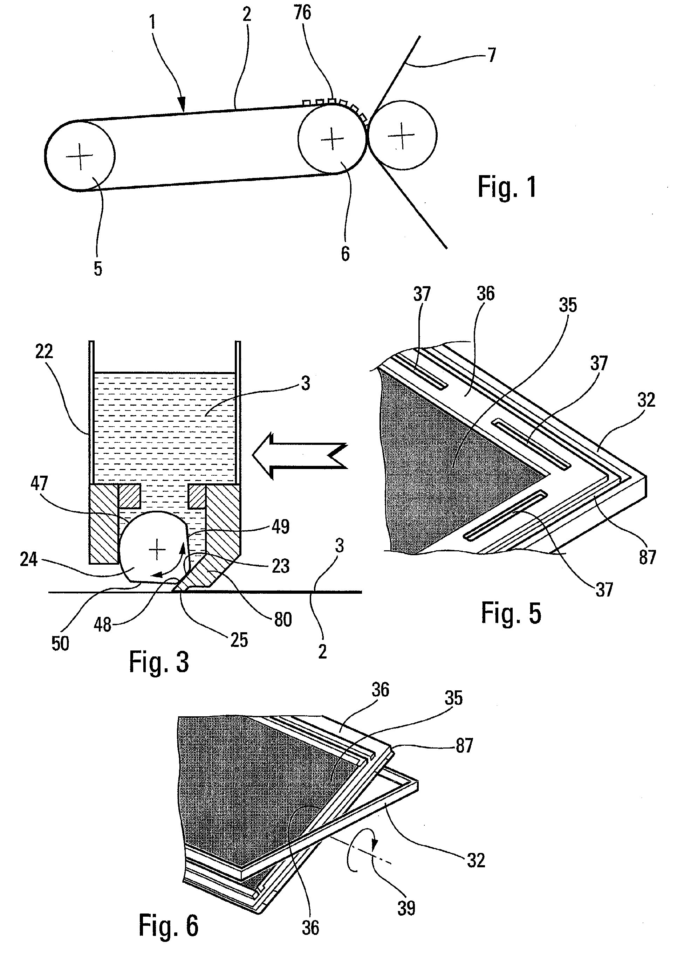

Comme on peut le voir à la figure 1, une telle ceinture d'impression 1 est utilisée dans l'imprimerie industrielle de typographie ou de flexographie : la ceinture d'impression 1 est disposée en boucle fermée autour de deux rouleaux d'entraînement 5,6 et est entraînée en rotation par ceux-ci. L'impression d'une bande de papier à imprimer 7 est réalisée par le contact sous pression de la bande de papier à imprimer 7 et des caractères d'impression 76 imprégnés d'encre.

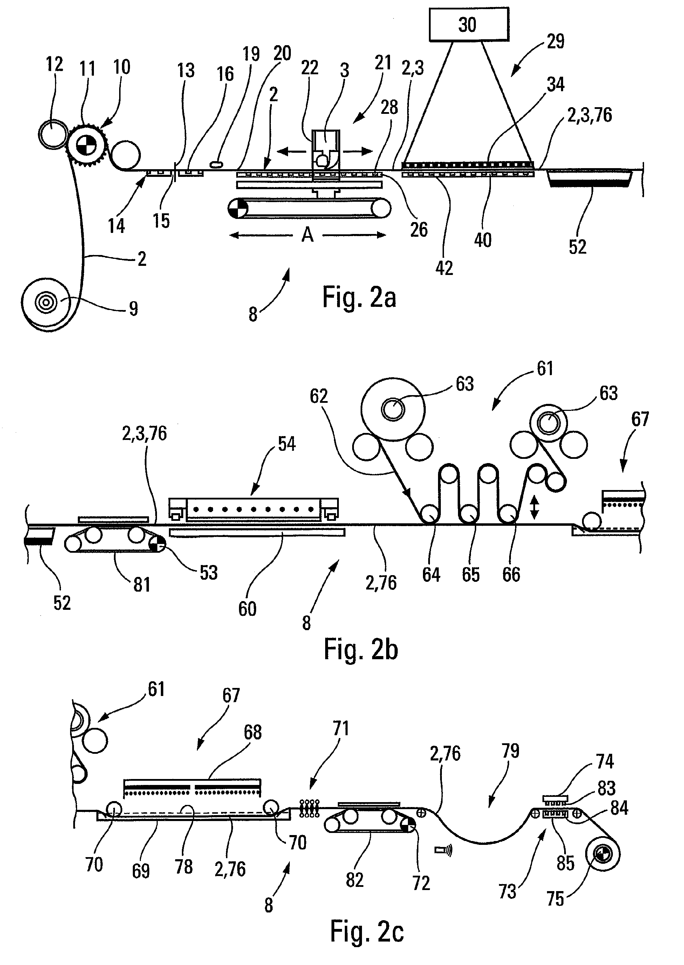

La figure 2 est un exemple particulier d'une chaîne de fabrication 8 conforme à la présente invention.

La chaîne de fabrication 8 comprend à son extrémité amont un rouleau dévidoir 9 de la bande formant support 2. Le rouleau dévidoir 9 est monté mobile en rotation et est dévidé au fur et à mesure pendant la fabrication de la ceinture d'impression 1.

La bande formant support 2 comprend des perforations le long de chacune de ses bordures latérales.

La chaîne de fabrication 8 comporte, en aval du rouleau dévidoir 9, une première paire de rouleaux d'entraînement 10 formant des moyens d'entraînement, chacun des rouleaux d'entraînement 10 étant disposé au droit des perforations de la bande formant support 2. Ces premiers rouleaux d'entraînement 10 sont munis, le long de leur périphérie, de picots 11 s'engrenant avec les perforations de la bande formant support 2, permettant l'entraînement de celle-ci de l'amont vers l'aval de la chaîne de fabrication 8.

De façon à assurer un bon entraînement de la bande formant support 2, une paire de roues de plaquage 12 munies d'une rainure de long de leur périphérie, la plaque contre les premiers rouleaux d'entraînement 10. Les picots 11 de chaque premier rouleau d'entraînement 10 se logent dans une rainures réalisée à la périphérie de la roue de plaquage 12 correspondante.

De façon à accepter des bandes formant support 2 de différentes largeurs, un premier rouleau d'entraînement 10 et la roue de plaquage 12 correspondante sont montées mobiles en translation par rapport à leur axe de rotation respectif. Afin de permettre la rotation du rouleau d'entraînement mobile 10, son arbre de rotation est cannelé.

La chaîne de fabrication 8 comporte, en aval de la première paire de rouleaux d'entraînement 10, des moyens de coupe adaptés à couper la bande formant support 2 quand elle est immobilisée.

Les moyens de coupe comprennent une lame de coupe 13 montée de façon mobile en translation dans la direction transversale de la bande formant support 2.

Au niveau de la lame de coupe 13, la bande formant support 2 est disposée sur un premier plateau 14. Le premier plateau 14 est divisée dans la direction longitudinale par une fente 15 transversale dans laquelle la lame de coupe 13 est adaptée à coulisser. Le premier plateau 14 comporte par ailleurs une série de rainures d'aspiration 16 débouchant à la surface sur laquelle repose la bande formant support 2. Les rainures d'aspiration 16 sont connectées à une pompe à vide permettant ainsi le plaquage de la bande formant support 2 de façon à assurer une coupe très précise de la bande formant support 2.

La chaîne de fabrication 8 comporte, en aval des moyens de coupe, des moyens de dépoussiérage.

Les moyens de dépoussiérage comprennent une brosse électrostatique 19 disposée à proximité immédiate de la face supérieure 20 de la bande formant support 2, adaptée à y enlever toute poussière incompatible avec un épandage très précis et régulier de la résine 3.

L'étape de dépoussiérage se fait quand la bande formant support 2 est déplacée.

La chaîne de fabrication 8 comporte, en aval de la brosse électrostatique 19, des moyens d'épandage 21 adaptés à épandre la résine 3 directement sur la face supérieure 20 de la bande formant support 2, et sur la quasi totalité de la largeur de celle-ci. Les moyens d'épandage 21 sont mobiles par rapport à la bande formant support 2.

Les moyens d'épandage 21 comportent une cuve 22 adaptée à contenir la résine 3 et des moyens de régulation adaptés à réguler la température, et par conséquent la viscosité, de la résine 3 liquide. La cuve 22 comporte, à sa partie inférieure, une ouverture 23 et un boisseau rotatif 24 mobile entre une position de fermeture et une position d'ouverture dans laquelle la résine 3 peut s'écouler au travers de l'ouverture 23. L'ouverture 23 étant l'espace compris entre l'axe de rotation du boisseau 24 et une paroi 80 de la cuve 22.

La cuve 22 comporte aussi un élément racleur 25 disposé sous l'ouverture 23et le boisseau rotatif 24, dans le prolongement de la paroi 80. Les moyens d'épandage 21 sont mobiles selon la direction longitudinale selon une amplitude maximale de translation A, l'élément racleur 25 est disposé en aval de l'ouverture 23 de façon à pouvoir niveler la résine 3 venant d'être étendue. L'ouverture 23 de la cuve 22 s'étend selon la direction transversale, perpendiculaire à la direction longitudinale.

De façon à accepter des bandes formant support 2 ayant des largeurs différentes, les moyens d'épandage 21 comprennent des moyens de réglage adaptés à régler la dimension de l'ouverture 23 dans la direction transversale.

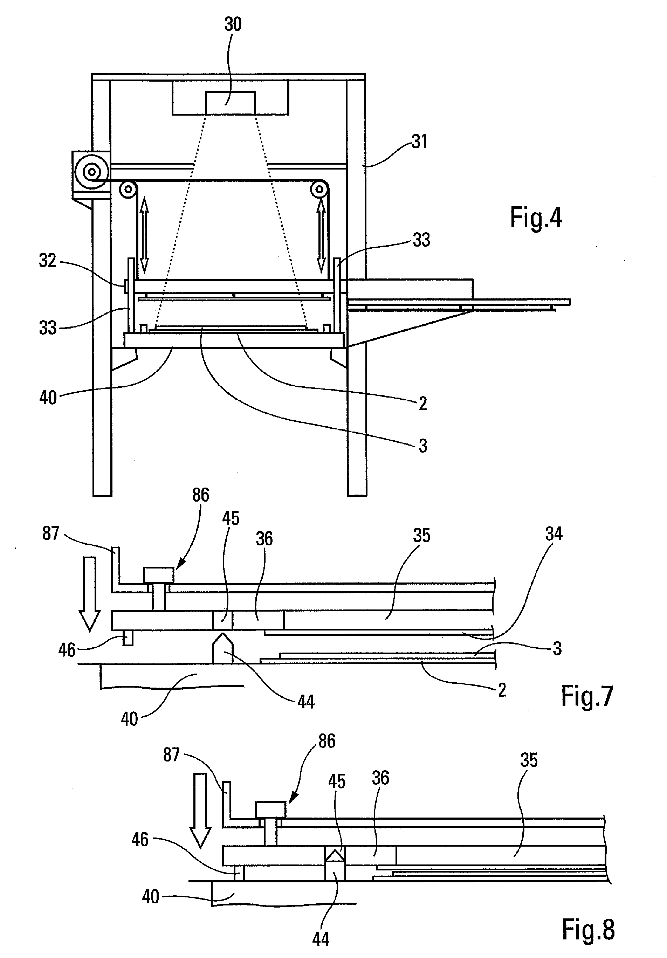

Dans l'exemple particulier illustré par les figures 2 et 3, le boisseau rotatif 24 est adapté à épandre la résine 3 selon deux largeurs, en fonction de la largeur de la bande formant support 2. Le boisseau rotatif 24 comprend, en section transversale, deux arcs de cercle 47,48, et entre ces deux arcs de cercle 47,48, deux segments 49,50. Le boisseau est en position de fermeture quand un arc de cercle 47,48 est au droit de l'ouverture 23 (et tangent à la paroi 80), et en position d'ouverture quand un segment 49,50 est au droit de l'ouverture 23.

Les deux arcs de cercle 47,48 et les deux segments 49,50 s'étendent dans la direction transversale, un des deux segments s'étendant au-delà de l'autre, le segment court étant alors remplacé par un arc de cercle complémentaire joignant les deux autres arcs de cercles 47,48.

Au niveau des moyens d'épandage 21, la bande formant support 2 est disposée sur un deuxième plateau 26 dont la surface sur laquelle repose la bande formant support 2 est particulièrement plane et est munie d'une série de rainures d'aspiration 28 y débouchant, connectées à une pompe à vide. Le deuxième plateau 26 comporte lui aussi des moyens de régulation de température.

Les moyens de régulation de la température (ceux de la cuve 22 et ceux du deuxième plateau 26), la planéité du deuxième plateau 26 et la présence de l'élément racleur 25 permettent un épandage de la résine 3 sur une épaisseur constante et précise, par exemple, sur une épaisseur de 530 µm avec une précision de 20 µm.

L'étape d'épandage se fait quand la bande formant support 2 est immobile, les moyens d'épandage 21 se déplaçant alors de leur position aval à leur position amont.

La chaîne de fabrication 8 comporte, en aval des moyens d'épandage 21, des moyens de photopolymérisation 29 adaptés à solidifier la partie de la résine 3 devant correspondre aux caractères d'impression 76.

Les moyens de photopolymérisation 29 comprennent une source lumineuse de photopolymérisation 30 disposée au-dessus de la bande formant support 2. Ils comprennent aussi un châssis 31, enjambant la bande formant support 2, et auquel est fixé la source lumineuse (lumière UV) de photopolymérisation 30.

Le châssis 31 est adapté à supporter, dans une position fixe, un film négatif 34 des caractères à réaliser qui est transparent à la lumière émise par la source lumineuse de photopolymérisation 30 uniquement aux emplacements des caractères.

Le châssis 31 comporte un cadre principal 32 disposé entre la source lumineuse 30 et la résine 3. Le cadre principal 32 est mobile verticalement entre une position haute et une position basse au plus près de la résine, et est guidé par des colonnes de guidage 33. Le cadre principal 32 est amovible : il peut être monté au delà de l'extrémité supérieure des colonnes de guidage 33 et désolidarisé du châssis 31.

Le film négatif 34 est disposé sur une vitre 35 transparente à la lumière émise par la source lumineuse de photopolymérisation 30 et entourée d'un cadre support 36, la vitre 35 étant fixe par rapport au cadre support 36. Le cadre support 36 comprend une série de rainures d'aspiration 37 débouchant à la surface contre laquelle le film négatif 34 est déposé. Ces rainures d'aspiration 37 permettent de disposer le film négatif 34 de la façon la plus plane possible sur la vitre 35, sans qu'il y ait de bulles d'air entre la vitre 35 et le film négatif 34 qui déformeraient les caractères en résine. Un premier système de repère permet de positionner de façon très précise le film négatif 34 par rapport au cadre support 36.

Le cadre support 36 est monté mobile par rapport à un cadre intermédiaire 87 qui l'entoure, et le cadre intermédiaire 87 est monté de façon mobile par rapport au cadre principal 32 qui l'entoure.

Un deuxième système de repère permet de positionner de façon très précise, dans les directions longitudinale et transversale, le cadre support 36 par rapport à la bande formant support 2, sans avoir de contraintes relative à la précision de la position longitudinale et transversale du cadre support 32. Ce deuxième système de repère comprend des plots 44 fixés sur un troisième plateau 40 sur lequel repose la bande formant support 2 au droit des moyens de photopolymérisation 29, de part et d'autre de la bande formant support 2. Par ailleurs, le cadre support 36 comprend des ouvertures 45 adaptées à s'encastrer dans les plots 44. Ces plots 44 et ces ouvertures 45 permettent d'avoir une position parfaitement définie du cadre support 36 malgré le jeu entre le cadre support 36 et le cadre intermédiaire 87, le cadre intermédiaire 87 et le cadre principal 32 et le cadre principal 32 et les colonnes de guidage 33.

Pendant la photopolymérisation, le film négatif 34 est disposé à proximité immédiate de la résine 3 de sorte que les caractères à reproduire sur la résine 3 ne soient pas déformés par la diffusion de la lumière.

Le cadre support 36 est monté mobile en translation dans la direction verticale par rapport au cadre intermédiaire 87 et il comprend des éléments de butée 46 disposés sur la surface contre laquelle le film négatif 34 est déposé. Ces éléments de butée 46 sont adaptés à venir en butée contre la surface supérieure du troisième plateau 40. Il est ainsi possible de définir de façon très précise la distance séparant le film négatif 34 de la résine 3 sans que la position verticale du cadre intermédiaire 87 (et du cadre principal 32) soit aussi précise du fait de l'amplitude de mouvement vertical des moyens de liaison 86 du cadre support 36 au cadre intermédiaire 87.

De façon à minimiser la distance séparant le film négatif 34 de la résine 3, le cadre intermédiaire 87 est monté mobile autour d'un axe de pivotement 39 par rapport au cadre principal 32 de sorte que la face de la vitre 35 contre laquelle est plaqué le film négatif 34 est la face la plus proche de la résine 3 (figures 7 et 8).

Le troisième plateau 40 comprend une surface supérieure particulièrement plane munie d'une série de rainures d'aspiration 42 connectées à une pompe à vide, permettant à la bande formant support 2 et à la résine 3 liquide préalablement nivelée par l'élément racleur 25 d'être particulièrement bien plane.

Pendant l'étape de photopolymérisation, la bande formant support 2 est immobile. Une fois la photopolymérisation de la partie de la résine située au droit du film négatif 34 réalisée, la bande formant support 2 est déplacée de l'amont vers l'aval d'une longueur égale au pas d'avancement.

La dimension de la zone de caractères du film négatif 34 dans la direction transversale est légèrement inférieure à la largeur de la résine 3 épandue sur la bande formant support 2, et celle dans le sens longitudinal est légèrement inférieure au pas d'avancement.

L'amplitude de translation des moyens d'épandage 21 est adaptée au film négatif 34 et est égale au pas d'avancement de sorte que la jonction entre deux nappes successives de résine 3 soit la plus étroite possible. Dans l'exemple la position aval des moyens d'épandage 21 est séparée de l'extrémité amont de la zone de la bande formant support 2 exposée à la source lumineuse de photopolymérisation 30 d'une distance égale au pas d'avancement de sorte que la zone de jonction se présente non pas au droit du film négatif 34, mais au droit de l'ensemble formé par le cadre support 36 et le cadre principal 32 (l'amplitude maximale A des moyens d'épandage 21 est bien supérieure au pas d'avancement).

La chaîne de fabrication 8 comporte, en aval des moyens de photopolymérisation 29, des moyens d'exposition dorsale.

Les moyens d'exposition dorsale comprennent une source lumineuse d'exposition dorsale 52 disposée au-dessous de la bande formant support 2. La source lumineuse d'exposition dorsale est adaptée à polymériser la couche de résine 3 la plus proche de la bande formant support 2, la bande formant support 2 étant au moins partiellement transparente à la lumière de la source lumineuse d'exposition dorsale 52. L'étape d'exposition dorsale permet d'assurer la fixation des caractères d'impression 76 réalisés lors de l'étape de photopolymérisation à la bande formant support 2.

L'étape d'exposition dorsale se fait pendant le déplacement de la bande formant support 2.

La chaîne de fabrication 8 comporte, en aval des moyens d'exposition dorsale 52, une deuxième paire de rouleaux d'entraînement 53 qui entraîne une première paire de courroies 81 munis de picots formant des moyens d'entraînement.

Les première et deuxième paires de rouleaux d'entraînement 10,53 permettent de donner à la bande formant support 2 une tension élevée (et donc une très bonne planéité) pendant les phases d'épandage, de photopolymérisation, et d'exposition dorsale.

La chaîne de fabrication 8 comporte, en aval de la paire de la deuxième paire de rouleaux d'entraînement 53, des moyens d'enlèvement 54 adaptés à enlever de la bande formant support 2 la résine 3 non photopolymérisée.

Les moyens d'enlèvement 54 comprennent un dispositif de soufflage d'air 55 propulsant de l'air en direction de la résine 3 liquide et solidifiée, et un bac de récupération 56 de la résine 3 liquide.

Le bac de récupération 56 est disposé face au dispositif de soufflage 55 par rapport à la direction de soufflage. De cette façon, la résine 3 liquide est détachée des caractères d'impression 76 et de la bande formant support 2 par l'air et, est entraînée dans le bac de récupération 56. Le bac de récupération 56 est disposé au plus près de la résine 3 de façon à minimiser la quantité de résine 3 liquide passant entre le bac de récupération 56 et la bande formant support 2. Par ailleurs, le bac de récupération 56 comprend une enceinte fermée 77 possédant une ouverture de réception 58 de la résine liquide 3 disposée à la partie inférieure de l'enceinte fermée 77, et des moyens d'aspiration 59 adaptés à aspirer les vapeurs de la résine 3 récupérée de façon à éviter la formation d'un brouillard de résine 3 hors de l'enceinte fermée 77.

Les moyens d'enlèvement 54 sont mobiles selon la direction transversale, l'étape d'enlèvement se faisant quand la bande formant support 2 est immobile. Le dispositif de soufflage 55 comprend une fente de soufflage 57 s'étendant selon la direction longitudinale selon une longueur légèrement supérieure au pas d'avancement de façon à enlever toute la résine en un seul passage.

De préférence, l'air soufflé et un quatrième plateau 60 sur lequel est disposée la bande formant support 2 au niveau des moyens d'enlèvement 54 sont chauffés de façon à augmenter la fluidité de la résine 3 liquide.

La chaîne de fabrication 8 comporte, en aval des moyens d'enlèvement 54, des moyens de nettoyage 61 adaptés à débarrasser les caractères d'impression 76 des traces de résine 3 liquide collée à leur surface.

Les moyens de nettoyage 61 comprennent une bande nettoyante 62 mobile en translation dans la direction longitudinale, dont la largeur est au moins égale à la largeur de la bande formant support 2, et dont chaque extrémité longitudinale est fixée à un cylindre de stockage 63. La bande nettoyante 62 est pressée contre les caractères d'impression par trois rouleaux d'application 64,65,66 successifs libres en rotation.

L'étape de nettoyage se fait quand la bande formant support 2 est déplacée, la bande nettoyante 62 tamponnant la surface des caractères au niveau des trois rouleaux d'application 64,65,66.

Dans l'exemple, les trois rouleaux d'application 64,65,66 sont mobiles verticalement entre une position basse dans laquelle ils pressent la bande nettoyante 62 contre les caractères d'impression 76 et une position haute.

La chaîne de fabrication 8 comporte, en aval des moyens de nettoyage 61, des moyens de post-exposition 67 adaptés à durcir les caractères d'impression.

Les moyens de post-exposition comprennent une source lumineuse de post-exposition 68 disposée au dessus de la bande formant support 2.

Les moyens de post-exposition 67 comprennent aussi une cuvette 69 remplie d'eau 78, la bande formant support 2 y étant dirigée par deux paires de roues 70 libres en rotation disposées au droit des bordures latérales de la bande formant support 2 de façon à ne pas abîmer les caractères d'impression 76. L'utilisation d'une telle cuvette 69 est particulièrement bien adaptée à certaines résines dont la polymérisation peut être gênée par la présence de d'oxygène, l'eau pouvant être remplacée par tout autre liquide de manière à avoir une post-exposition anaérobie.

Une roue de chaque paire de roues 70 est montée mobile en translation par rapport à son axe de rotation, de façon à accepter des bandes formant support 2 de largeur différente.

L'étape de post-exposition se fait pendant le déplacement de la bande formant support 2.

La chaîne de fabrication 8 comporte, en aval des moyens de post-exposition 67, des moyens de séchage 71 adaptés à sécher la bande formant support 2 sortant de la cuvette 69.

Ces moyens de séchage 71 peuvent comprendre plusieurs rampes propulsant de l'air chaud.

La chaîne de fabrication 8 comporte, en aval des moyens de séchage 71, une troisième paire de rouleaux d'entraînement 72 qui entraîne une deuxième paire de courroies 82 munis de picots formant des moyens d' entraînement.

Ces troisièmes rouleaux d'entraînement 72 sont similaires aux seconds rouleaux d'entraînement 53. Les deuxième et troisième paires de rouleaux d'entraînement 53,72 permettent de donner à la bande formant support 2 une tension plus faible qu'entre les première et deuxième paires de rouleaux d'entraînement 10,53 de façon à ne pas abîmer les caractères d'impression 76, notamment lors du guidage de la bande formant support 2 dans la cuvette 69.

La chaîne de fabrication 8 comporte, en aval de la paire de troisièmes rouleaux d'entraînement 72, des moyens d'arrêt 73 adaptés à maintenir immobile la partie de la bande formant support 2 qui y est fixée tout en laissant libre de mouvement la partie se trouvant en amont.

Ces moyens d'arrêt 73 comprennent un paire de peignes 74 dont chaque dent 83 est adaptée à traverser les perforations latérales de la bande formant support 2 et à pénétrer dans les trous 84 réalisés sur la surface supérieure d'un cinquième plateau 85 sur lequel repose la bande formant support 2 de façon à maintenir la bande formant support 2 dans son axe longitudinal de progression. Ces moyens d'arrêt 73 sont particulièrement adaptés lors de l'utilisation d'une même bande formant support 2 comme support des caractères d'impression 76 pour plusieurs ceintures d'impression 1.

La chaîne de fabrication 8 comporte, en aval des moyens d'arrêt 73, un rouleau de réception 75 monté mobile en rotation, adapté à recevoir la bande formant support 2 munie des caractères d'impression 76.

Le procédé de fabrication de la ceinture d'impression 1 réalisée sur la chaîne de fabrication 8 illustrée à la figure 2 comprend une succession de périodes d'immobilisation pendant lesquelles la bande formant support 2 est immobile et de périodes de déplacement pendant lesquelles la bande formant support 2 est déplacée par les moyens d'entraînement 10,53,72 d'une longueur égale au pas de déplacement de sorte que chaque section transversale de la bande formant support 2 subisse les différentes étapes du procédé de fabrication.

Les étapes de dépoussiérage, d'exposition dorsale, de nettoyage, de post-exposition et de séchage se font pendant les périodes de déplacement, et les étapes d'épandage, de photopolymérisation et d'enlèvement se font pendant les périodes d'immobilisation.

Pendant les périodes de déplacement, le cadre principal 32 est mis en position haute et remplacé par un cadre principal 32 muni du nouveau film négatif 34 qui est mis en position basse et est positionné précisément par rapport à la bande formant support 2, les moyens d'enlèvement 54 sont déplacés transversalement vers leur position de début de cycle sans que de l'air soit soufflé, et la bande nettoyante 62 est déplacée dans le même sens que la bande formant support 2, les rouleaux d'application 64,65,66 étant dans leur position basse.

Pendant les périodes d'immobilisation, les moyens d'épandage 21 sont déplacés longitudinalement de leur position amont proche des moyens de dépoussiérage 19 vers leur position aval proche des moyens de photopolymérisation 29, l'ouverture 23 de la cuve 22 étant fermée, puis ils sont déplacés longitudinalement de leur position aval vers leur position amont, l'ouverture 23 de la cuve 22 étant ouverte, le prochain film négatif 34 est fixé à un cadre support 36 désolidarisé du châssis 31, les moyens d'enlèvement 54 sont déplacés transversalement, de l'air étant soufflé, les rouleaux d'application 64,65,66 sont déplacés vers leur position haute, la bande nettoyante 62 est ensuite déroulée dans le sens de l'amont vers l'aval d'une longueur suffisante pour que toute surface ayant été en contact avec les caractères d'impression 76 se trouve en aval du rouleau d'application aval 66, et les rouleaux d'application 64,65,66 sont déplacés de leur position haute à leur position basse.

Quand la bande formant support 2 est utilisée pour plusieurs ceintures d'impression 1, les derniers caractères de la première ceinture d'impression 1 peuvent n'êtres séparés des premiers caractères de la deuxième ceinture d'impression 1 que de deux pas d'avancement de sorte que les moyens d'épandage 21 les moyens de photopolymérisation 29 restent en phase. Il est alors possible, quand les derniers caractères de la première ceinture d'impression 1 sont en aval des moyens d'arrêt 73, d'arrêter le mouvement du rouleau de réception 75 indépendamment du reste de la chaîne de fabrication 8 (la deuxième ceinture d'impression 1 continuant d'être fabriquer s'accumulant dans une zone tampon 79 entre les moyens d'arrêt 73 et la troisième paire de rouleaux d'entraînement 72), de fixer l'extrémité de la deuxième ceinture d'impression 1 aux moyens d'arrêt 73, de couper la bande formant support 2 et de séparer ainsi les deux ceintures d'impression, de remplacer le premier rouleau de réception 75 et de fixer l'extrémité libre de la deuxième ceinture d'impression 2 au nouveau rouleau d'impression 75.

Bien évidemment, la présente invention n'est pas limitée au mode de réalisation qui vient d'être décrit en détail.

Les moyens d'épandage 21 décrits ci-dessus peuvent être remplacés par des moyens équivalents, ils peuvent être montés mobiles transversalement ou fixes, l'étape d'épandage se faisant alors quand la bande formant support 2 est déplacée.

Les moyens de photopolymérisation 29 décrits ci-dessus peuvent être remplacés par des moyens équivalents, par exemple, par des sources de rayonnement laser commandées numériquement, permettant un déplacement continu de la bande formant support 2, sans périodes d'immobilisation.

La source lumineuse d'exposition dorsale 52 peut être montée de façon mobile, l'étape d'exposition dorsale pouvant alors se faire quand la bande formant support 2 est immobile.

Les moyens d'enlèvement 54 décrits ci-dessus peuvent être remplacés par des moyens équivalents, ils peuvent être montés mobiles longitudinalement ou fixes, l'étape d'enlèvement se faisant alors quand la bande formant support 2 est déplacée.

Les moyens de nettoyage 61 décrits ci-dessus peuvent être remplacés par des moyens équivalents, ils peuvent être mobiles, l'étape de nettoyage pouvant alors se faire quand la bande formant support 2 est immobile.

Les moyens de post-exposition 67 décrits ci-dessus peuvent être remplacés par des moyens équivalents, il est notamment possible de supprimer la cuvette 69 selon le type de résine utilisée, la source lumineuse de post-exposition 68 pouvant être mobile, l'étape de post-exposition pouvant alors se faire quand la bande formant support 2 est immobile.

Les moyens de séchage 71 décrits ci-dessus peuvent être remplacés par des moyens équivalents, ils peuvent être montés de façon mobile, l'étape de séchage pouvant alors se faire quand la bande formant support 2 est immobile.

De plus, une telle chaîne de fabrication 8, avec toutes ces étapes, permet de fabriquer des ceintures d'impression d'une très grande qualité. Il serait possible de supprimer les moyens de dépoussiérage 19, les moyens d'exposition dorsale 52, les moyens de nettoyage 61, les moyens de post-exposition 67, les moyens de séchage 71, ou certains d'entre eux uniquement. Il serait aussi possible de ne pas donner à la bande formant support 2 deux tensions différentes selon la position dans la chaîne de fabrication 8. Il serait aussi possible de ne pas avoir de lame de coupe 13, ni de moyens d'arrêt 73.

## Revendications

1. Procédé de fabrication d'une ceinture d'impression (1) comprenant une bande formant support (2) et une résine (3) photopolymérisée, disposée sur une face de la bande (2), et formant les caractères d'impression (76), le procédé comportant une étape d'épandage pendant laquelle la résine (3) liquide est épandue sur une surface plane, une étape de photopolymérisation pendant laquelle seule la partie de la résine (3) devant correspondre aux caractères d'impression (76) est soumise à une exposition lumineuse de façon à être solidifiée, et une étape d'enlèvement pendant laquelle la résine (3) non photopolymérisée est enlevée de la surface sur laquelle elle a été épandue, **caractérisé en ce que** la résine (3) liquide est épandue directement sur la face supérieure de la bande formant support (2) disposée horizontalement, et **en ce que** la bande formant support (2) est montée mobile longitudinalement en translation de sorte que chaque section transversale de la bande formant support (2) passe successivement d'un moyen permettant la réalisation d'une étape de fabrication à un autre.

2. Procédé de fabrication selon la revendication 1, **caractérisé en ce qu'**il comprend une succession de périodes d'immobilisation pendant lesquelles la bande formant support (2) est immobile et de périodes de déplacement pendant lesquelles la bande formant support (2) est déplacée par des moyens d'entraînement (10,53,72) de la longueur d'un pas de déplacement.

3. Procédé de fabrication selon la revendication 2, **caractérisé en ce que** la photopolymérisation est réalisée pendant les périodes d'immobilisation, une source lumineuse de photopolymérisation (30) étant disposée au-dessus de la résine (3), et un élément formant masque (34), constituant le négatif des caractères à réaliser, étant disposé entre la résine (3) et la source lumineuse (30), à proximité immédiate de la résine (3), la zone de caractères du film négatif (34) étant d'une longueur légèrement inférieure au pas de déplacement.

4. Chaîne de fabrication (8) d'une ceinture d'impression (1) comprenant une bande formant support (2) et une résine (3) photopolymérisée, disposée sur une face de la bande formant support (2), formant des caractères d'impression (76), la chaîne de fabrication (8) comportant des moyens d'épandage (21) adaptés à épandre la résine (3) liquide, des moyens de photopolymérisation (29) adaptés à solidifier la partie de la résine (3) devant correspondre aux caractères d'impression (76), et des moyens d'enlèvement (54) adaptés à enlever la résine (3) non photopolymérisée de la surface sur laquelle elle a été épandue, **caractérisé en ce que** les moyens d'épandage (21) sont adaptés à épandre la résine (3) directement sur la face supérieure de la bande formant support (2), **en ce que** les moyens de photopolymérisation (29) sont disposés en aval des moyens d'épandage (21) et comprennent une source lumineuse de photopolymérisation (30) disposée au-dessus de la résine (3), **en ce que** les moyens d'enlèvement (54) sont disposés en aval des moyens de photopolymérisation (29), et **en ce que** des moyens d'entraînement (10,53,72) sont adaptés à entraîner la bande formant support (2), en translation selon une direction longitudinale, de sorte que chacune de ses sections transversales passe successivement au droit des moyens d'épandage (21), des moyens de photopolymérisation (29) et des moyens d'enlèvement (54).

5. Chaîne de fabrication (8) selon la revendication 4, **caractérisée en ce qu'**elle comprend des moyens d'exposition dorsale (52) disposés en aval des moyens de photopolymérisation (29) et en amont des moyens d'enlèvement (54), comprenant une source lumineuse d'exposition dorsale (52) disposée au dessous de la bande formant support (2), et adaptés à polymériser la couche de la résine (3) la plus proche de la bande formant support (2) de façon à assurer la fixation des caractères d'impression (76) à la bande formant support (2).

6. Chaîne de fabrication (8) selon la revendication 4 ou 5, **caractérisée en ce qu'**elle comprend des moyens de nettoyage (61) disposés en aval des moyens d'enlèvement (54), adaptés à débarrasser les caractères d'impression (76) des traces de résine (3) liquide collée à leur surface.

7. Chaîne de fabrication (8) selon l'une des revendications 4 à 6, **caractérisée en ce qu'**elle comprend des moyens de post-exposition (67) adaptés à durcir les caractères d'impression (76) et disposés en aval des moyens d'enlèvement (54), comprenant une source lumineuse de post-exposition (68) disposée au-dessus de la bande formant support (2).

8. Chaîne de fabrication (8) selon l'une des revendications 4 à 7, **caractérisée en ce qu'**elle comprend des moyens de dépoussiérage (19) disposés en amont des moyens d'épandage (21) adaptés à enlever toute poussière de la face supérieure de la bande formant support (2).

9. Chaîne de fabrication (8) selon l'une des revendications 4 à 8, **caractérisée en ce qu'**elle comprend à son extrémité amont un rouleau dévidoir (9) duquel est dévidé la bande formant support (2).

10. Chaîne de fabrication (8) selon l'une des revendications 4 à 9, **caractérisée en ce qu'**elle comprend à son extrémité aval un rouleau de réception (75) recevant la bande formant support (2) munie des caractères d'impression (76).

11. Chaîne de fabrication (8) selon l'une des revendications 4 à 10, **caractérisée en ce que** les moyens de photopolymérisation (29) comprennent un châssis (31) sur lequel est monté de façon amovible et mobile un élément formant masque (34), constituant le négatif des caractères à réaliser, disposé entre la source lumineuse (30) et la résine (3), à proximité immédiate de la résine (3).

12. Chaîne de fabrication (8) selon l'une des revendications 4 à 11, **caractérisée en ce que** les moyens d'épandage (21) sont mobiles dans la direction longitudinale.

13. Chaîne de fabrication (8) selon l'une des revendications 4 à 12, **caractérisée en ce que** les moyens d'épandage (21) comportent une cuve (22) adaptée à contenir la résine (3) liquide et comprenant, à sa partie inférieure, une ouverture (23) et un boisseau rotatif (24) entre une position de fermeture et une position d'ouverture dans laquelle la résine peut s'écouler au travers de l'ouverture (23).

14. Chaîne de fabrication (8) selon l'une des revendications 4 à 13, **caractérisée en ce que** les moyens d'épandage (21) comprennent un élément racleur (25) adapté à niveler la résine (3) épandue sur la bande formant support (2).

15. Chaîne de fabrication (8) selon l'une des revendications 4 à 14, **caractérisée en ce que** les moyens d'enlèvement (54) comprennent un dispositif de soufflage d'air (55) adapté à propulser de l'air en direction de la résine (3) liquide et solidifiée, et un bac de récupération (56) de la résine liquide (3) détachée de la bande formant support (2) par l'air propulsé, le bac étant disposé face au dispositif de soufflage d'air (55) par rapport à la direction de soufflage et à proximité immédiate de la résine (3).

16. Chaîne de fabrication (8) selon la revendication 15, **caractérisée en ce que** le bac de récupération (56) comprend des moyens d'aspiration (59) adaptés à aspirer les vapeurs de la résine (3) récupérée de façon à éviter la formation d'un brouillard de résine (3) hors du bac de récupération (56).

17. Chaîne de fabrication (8) selon l'une des revendications 4 à 16, **caractérisée en ce que** les moyens d'enlèvement (54) sont mobiles transversalement.

18. Chaîne de fabrication (8) selon l'une des revendications 4 à 17, **caractérisée en ce que** les moyens d'entraînement (10,53,72) comprennent une première paire de rouleaux d'entraînement (10) en amont des moyens d'épandage (21), une deuxième paire de rouleaux d'entraînement (53) entre les moyens de photopolymérisation (29) et les moyens d'enlèvement (54), et une troisième paire de rouleaux d'entraînement (72) en fin de chaîne de fabrication (8), de façon à conférer à la bande formant support une tension élevée entre la première et la deuxième paire de rouleaux d'entraînement (10,53), et une tension plus faible en aval de la deuxième paire de rouleaux d'entraînement (53).

19. Chaîne de fabrication (8) selon l'une des revendications dépendantes de la revendication 7, **caractérisée en ce que** les moyens de post-exposition (67) comprennent une cuvette (69) remplie d'un liquide (78) située au droit de la source lumineuse de post-exposition (68) et dans laquelle est dirigée la bande formant support (2) de sorte que la photopolymérisation de la surface des caractères d'impression (76) pendant l'étape de post-exposition soit faite dans un milieu anaérobie.

20. Chaîne de fabrication (8) selon la revendication 19, **caractérisée en ce qu'**elle comprend des moyens de séchage (71) en aval de la cuvette (69).

21. Chaîne de fabrication (8) selon l'une des revendications 4 à 20, **caractérisée en ce qu'**elle est adaptée à recevoir des bandes formant support (2) de largeur différentes.

22. Chaîne de fabrication (8) selon la revendication 21, **caractérisée en ce que** chaque paire de rouleaux d'entraînement (10,53,72) comprend au moins un rouleaux d'entraînement monté mobile en translation le long de son arbre de rotation.

23. Chaîne de fabrication (8) selon la revendication 21 dépendante de la revendication 13, **caractérisée en ce que** le boisseau (24) comprend, en section transversale, deux arcs de cercle (47,48) tangents à une paroi (80) de la cuve (22) définissant l'ouverture d'épandage (23), et entre ces deux arcs de cercle (47,48), deux segments (49,50), un des deux segments (49,50) s'étendant au-delà du deuxième segment dans la direction de l'axe de rotation du boisseau (24) de façon à définir deux largeur d'épandage.
